Europäisches Patentamt

European Patent Office

Office européen des brevets

(19)

(11) Numéro de publication: **0 090 412**
**A2**

# (12) DEMANDE DE BREVET EUROPEEN

(21) Numéro de dépôt: **83103117.4**

(22) Date de dépôt: **29.03.83**

(51) Int. Cl.³: **G 11 C 5/00,** H 02 H 7/18,
H 02 J 9/06

---

(30) Priorité: **31.03.82 FR 8205499**

(43) Date de publication de la demande: **05.10.83**
**Bulletin 83/40**

(84) Etats contractants désignés: **AT BE CH DE FR GB IT LI
LU NL SE**

(71) Demandeur: **GIPELEC Société Anonyme dite :, 125, rue
du Président Wilson, F-92302 Levallois-Perret (FR)**

(72) Inventeur: **Arzur, Jean-Paul, 25, rue Edouard Grimaud,
F-86000 Poitiers (FR)**
Inventeur: **Broussely, Michel, 53, avenue de Poitiers,
F-86240 Liguge (FR)**

(74) Mandataire: **Weinmiller, Jürgen et al, Zeppelinstrasse 63,
D-8000 München 80 (DE)**

---

(54) Dispositif générateur de courant notamment pour préservation des mémoires vives volatiles.

(57) Le dispositif générateur comporte une pile (1) et une diode (2) en série, et une résistance (3) en parallèle sur la pile. La résistance a une très forte valeur afin que le courant ($i_R$) qui la traverse soit toujours au moins égal au courant inverse ($i_d$) de la diode.

L'ensemble peut être encapsulé dans une résine et se présenter sous la forme d'un composant (5) comportant trois bornes (A, B, C) de raccordement.

0090412

Dispositif générateur de courant notamment pour préservation des mémoires vives volatiles

L'invention concerne les générateurs de courant utilisés pour préserver les mémoires vives volatiles, notamment les mémoires statiques en technologie C-MOS par exemple, lors des pannes d'alimentation.

De telles mémoires sont couramment utilisés dans les microprocesseurs.

La fonction de préservation est généralement assurée par des générateurs primaires, ou batteries de générateurs, de basse tension, de 3 ou 6 volts par exemple. Un montage classique consiste à utiliser une pile en série avec une diode qui isole la pile du circuit dont la tension normale d'alimentation est supérieure, la diode empêchant qu'un courant de sens opposé au courant de décharge de la pile ne traverse celle-ci ce qui lui serait néfaste. La pile est en effet, dans cette application, un générateur primaire, théoriquement non réversible et non conçu pour être rechargé. Une diode n'ayant pas une résistance inverse infinie, il circule toujours un faible courant de fuite qui traverse la pile. La difficulté réside dans la détermination du courant maximum admissible par la pile, dans le sens opposé au courant de décharge, sachant que ce phénomène doit se poursuivre pendant une durée très longue, de plusieurs années, par exemple dix ans. Cette difficulté entrave la fiabilité intrinsèque de la pile dans cette application.

L'invention a pour but de remédier aux inconvénients d'une telle solution.

L'invention concerne un dispositif générateur de courant pour préservation des mémoires vives volatiles comportant une pile et une diode en série, caractérisé par le fait qu'il comporte une résistance en parallèle sur la pile, ladite résistance ayant une valeur telle que la pile soit toujours en décharge de manière que le courant dans la résistance soit toujours au moins égal au courant inverse de la diode.

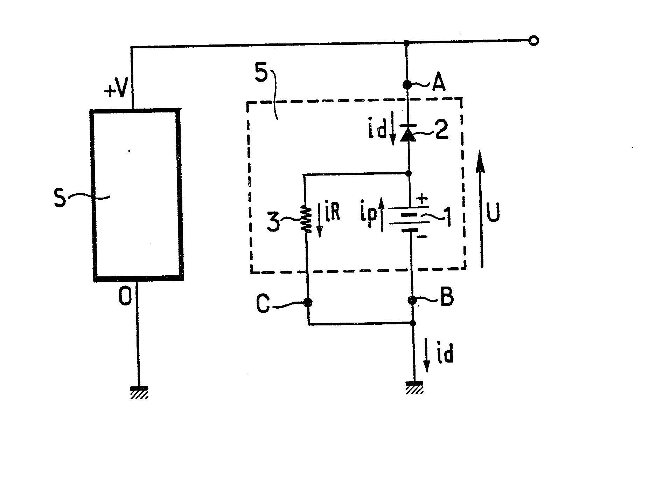

L'invention sera bien comprise à l'aide de la description qui va suivre d'un exemple de réalisation illustré par la figure unique annexée, dans laquelle 1 est une pile, de tension U de 3 volts par exemple, 2 une diode, et 3 une résistance de très forte valeur en parallèle sur la pile. L'ensemble est relié aux bornes d'une source continue S dont les potentiels sont repérés par 0 et +V, par exemple 0 et + 5 volts, alimentant normalement les mémoires, ou les microprocesseurs ; le potentiel 0 est relié à la masse. La diode 2 est en série avec la pile 1 qui débite à travers la diode lorsque la tension de la source continue devient inférieure à 3 volts ; la diode 2 est donc polarisée en inverse lorsque la tension de la source continue S est supérieure à 3 volts. La résistance 3, de valeur R, étant connectée en parallèle sur la pile, est parcourue par un courant iR égal à U/R, soit 3/R ampères avec U = 3 volts. Dans la diode 2, aux bornes de laquelle on a une tension V - U, soit 2 volts avec U = 5 et V = 3 volts, il circule un courant inverse id. Par conséquent la pile 1 délivre un courant ip tel que iR = ip + id. Par un choix judicieux de la valeur R de la résistance 3 on obtiendrait iR = id, soit un courant ip = 0 ; en d'autres termes, le courant de fuite développe dans la résistance R une différence de potentiel égale à la force électromotrice de la pile ; la pile ne débiterait donc pas. Le courant inverse id de la diode pouvant être variable, et notamment augmenter avec la température, on choisira iR $\gg$ id, ce qui entraine ip $>$ o, ces relations étant satisfaites pour le courant inverse maximum qui peut traverser la diode 2 lors du fonctionnement du dispositif générateur. Ainsi la pile fonctionne toujours dans le sens normal, c'est-à-dire en décharge. Bien entendu le courant ip qu'elle délivre sera aussi faible que possible. A titre d'exemple le courant inverse d'une diode, pour un type de diode donné, se situe, entre 5 et 20 nanoampères à la température ambiante, et peut atteindre 100 à 150 nanoampères à la température de 100°C. Avec une pile au lithium manganèse d'une tension de 3 volts et d'une capacité de 190 mAh par exemple, et une résistance de 10 mégohms en parallèle, le courant iR dans la résistance est de 300 nanoampères. Avec un courant inverse id dans la diode de par exemple 10 nanoampères pour une source continue S de tension 5 volts, le courant ip débité par la pile est ip = iR - id = 290 nanoampères. Ce courant représente une perte de capacité de 2,3 mAh par an, soit environ 1,2% de la capacité de la pile. Cette perte de capacité, dont on doit tenir compte dans les applications auxquelles le dispositif générateur est destiné, est suffisamment faible pour que le dispositif générateur puisse fonctionner correctement pendant toute la durée de vie qui lui est demandée, par exemple plusieurs années. L'énergie réellement fournie, en secours, par un dispositif générateur est relativement peu importante, d'autant que pour des durées aussi longues on fait appel à des piles à anode de lithium, à faible autodécharge et forte énergie spécifique. L'inconvénient présenté par la perte de capacité de la pile, perte due à la présence de la résistance 3, est très largement compensée par la fiabilité ainsi apportée à la fonction maintien de la mémoire.

Le dispositif générateur objet de l'invention peut se présenter avantageusement sous la forme d'un composant électronique 5 encapsulé dans une résine ; ce composant qui est constitué par la pile 1, la diode 2 et la résistance 3 comporte trois bornes A, B et C pour son raccordement. Au moment de l'utilisation, les bornes B et C sont toutes deux mises au potentiel O (masse). De cette manière, la pile n'est mise en décharge que lors de l'utilisation, et non aussitôt après fabrication du dispositif. Bien entendu la résine doit être un bon isolant électrique afin de ne pas créer une résistance de fuite.

REVENDICATIONS

1/ Dispositif générateur de courant pour préservation des mémoires vives volatiles comportant une pile (1) et une diode (2) en série, caractérisé par le fait qu'il comporte une résistance (3) en parallèle sur la pile, ladite résistance ayant une valeur telle que la pile soit toujours en décharge de manière que le courant (iR) dans la résistance soit toujours au moins égal au courant inverse (id) de la diode.

2/ Dispositif générateur de courant selon la revendication 1, caractérisé par le fait que la pile (1), la diode (2), et la résistance (3) sont encapsulées dans une résine électriquement isolante, et constituent un composant électronique (5) ayant trois bornes (A, B et C) de raccordement.